# EUROPEAN PATENT APPLICATION

(11) **EP 4 844 546 A1**
(43) Date of publication of application: **25.11.2026**
(21) Application number: 25177289.3
(22) Date of filing: 19.05.2025
(51) Int. Cl.: G06F 3/041, G06F 3/044

(54) **TOUCH SENSING METHOD AND APPARATUS**

(71) Applicant: NXP B.V., 5656 AG Eindhoven (NL)
(72) Inventor: Guatama, Temujin, 5656AG Eindhoven (NL)
(74) Representative: Schwarzweller, Thomas

(57) **Abstract**

A method and apparatus of touch sensing for a capacitive touch sensor array is described. The capacitive touch sensor array includes rows and columns of electrodes. Sensor signals are transmitted via rows of electrodes and received via columns of electrodes or vice versa. A capacitance value is estimated or each crosspoint of the rows of electrodes and the plurality of columns of electrodes from the received sensor signals. A crosspoint baseline capacitance value is determined for a crosspoint between a row and a column from an aggregate capacitance value of the row and an aggregate capacitance value of the column.

## Description

### FIELD

This disclosure relates to a method of touch sensing for a capacitive touch sensor and a touch screen sensing apparatus for a capacitive touch sensor array.

### BACKGROUND

In capacitive touchscreens, user input is measured using mutual capacitance between pairs of electrodes that are arranged in an array which may be referred to as a capacitive touch sensor array. When a finger comes close to a pair of electrodes, the mutual capacitance between a row electrode and columns electrode changes. This change is detected as a change with respect to a predetermined baseline value at intersections or crosspoints between row electrodes and column electrodes which may be referred to as a heatmap. The change in capacitance values in the heatmap indicates the region or regions of the touch screen which is in contact with or close to the finger.

### SUMMARY

Aspects of the disclosure are defined in the accompanying claims. In a first aspect, there is provided a method of touch sensing for a capacitive touch sensor array, the capacitive touch sensor array comprising a plurality of rows of electrodes and a plurality of columns of electrodes, the method comprising: transmitting a plurality of transmit signals via one of the plurality of rows of electrodes and the plurality of columns of electrodes; receiving a plurality of sensor signals via the other of the plurality of rows of electrodes and the plurality of columns of electrodes; estimating a capacitance value for a plurality of crosspoints between the plurality of rows of electrodes and the plurality of columns of electrodes from the plurality of sensor signals; and determining a crosspoint baseline capacitance value for a crosspoint between a row and a column from an aggregate capacitance value of the row and an aggregate capacitance value of the column.

In some embodiments, determining the crosspoint baseline capacitance value further comprises multiplying the aggregate capacitance value of the row and the aggregate capacitance value of the column. In some embodiments, the aggregate capacitance value of the row comprises an average value of a plurality of crosspoints of the row; and the aggregate capacitance value of the column comprises an average value of a plurality of crosspoints of the column. In some embodiments, the aggregate capacitance value of the row comprises a median value of a plurality of crosspoints of the row; and the aggregate capacitance value of the column comprises a median value of a plurality of crosspoints of the column. In some embodiments, compensating a capacitance value for a crosspoint dependent on the crosspoint baseline capacitance value and generating a compensated heatmap from the compensated capacitance value. In some embodiments, the method further comprises processing the compensated heatmap to reduce interference. In some embodiments, the method further comprises detecting touch events from the processed compensated heatmap.

In a second aspect, there is provided a touchscreen processor for a capacitive touch sensor array, the capacitive touch sensor array comprising a plurality of rows of electrodes and a plurality of columns of electrodes, the touchscreen processor comprising a baseline estimator configured to: transmit a plurality of transmit signals via one of the plurality of rows of electrodes and the plurality of columns of electrodes; receive a plurality of sensor signals via the other of the plurality of rows of electrodes and the plurality of columns of electrodes; estimate a capacitance value for a plurality of crosspoints of the plurality of rows of electrodes and the plurality of columns of electrodes from the plurality of sensor signals; and determine a crosspoint baseline capacitance value for a crosspoint between a row and a column from an aggregate capacitance value of the row and an aggregate capacitance value of the column.

In some embodiments, the baseline estimator is further configured to determine a crosspoint baseline capacitance value by multiplying the aggregate capacitance value of the row and the aggregate capacitance value of the column. In some embodiments, the aggregate capacitance value of the row comprises an average value of a plurality of crosspoints of the row; and the aggregate capacitance value of the column comprises an average value of a plurality of crosspoints of the column. In some embodiments, the aggregate capacitance value of the row comprises a median value of a plurality of crosspoints of the row; and the aggregate capacitance value of the column comprises a median value of a plurality of crosspoints of the column. In some embodiments, the touchscreen processor further comprises a baseline compensator coupled to the baseline estimator wherein the baseline compensator is configured to: receive a plurality of baseline capacitance values from the baseline estimator; compensate a capacitance value for a crosspoint dependent on the crosspoint baseline capacitance value ; and output a compensated heatmap. In some embodiments, the touchscreen processor further comprises an interference reducer configured to process the compensated heatmap to reduce interference. In some embodiments, the touchscreen processor further comprises detecting touch events from the processed compensated heatmap.

In a third aspect, there is provided a non-transitory computer readable media comprising a computer program comprising computer executable instructions which, when executed by a computer, causes the computer to perform a method of touch sensing for a capacitive touch sensor array, the capacitive touch sensor array comprising a plurality of rows of electrodes and a plurality of columns of electrodes, the method comprising: transmitting a plurality of transmit signals via one of the plurality of rows of electrodes and the plurality of columns of electrodes; receiving a plurality of sensor signals via the other of the plurality of rows of electrodes and the plurality of columns of electrodes; estimating a capacitance value for each crosspoint of the plurality of rows of electrodes and the plurality of columns of electrodes from the plurality of sensor signals; and determining a crosspoint baseline capacitance value for a crosspoint between a row and a column from an aggregate capacitance value of the row and an aggregate capacitance value of the column.

In some embodiments, determining a crosspoint baseline capacitance value comprises multiplying the aggregate capacitance value of the row and the aggregate capacitance value of the column. In some embodiments, the aggregate capacitance value of the row comprises an average value of a plurality of crosspoints of the row; and the aggregate capacitance value of the column comprises an average value of a plurality of crosspoints of the column. In some embodiments, the aggregate capacitance value of the row comprises a median value of a plurality of crosspoints of the row; and the aggregate capacitance value of the column comprises a median value of a plurality of crosspoints of the column. In some embodiments, the method further comprises: compensating a capacitance value for a crosspoint dependent on the crosspoint baseline capacitance value and generating a compensated heatmap from the compensated capacitance value. In some embodiments, the method further comprises processing the compensated heatmap to reduce interference and detecting touch events from the processed compensated heatmap.

### BRIEF DESCRIPTION OF THE DRAWINGS

In the figures and description like reference numerals refer to like features. Embodiments are now described in detail, by way of example only, illustrated by the accompanying drawings in which:
Figure 1A shows a typical touchscreen array.
Figure 1B illustrates a touch screen sensing apparatus including a baseline estimator according to an embodiment.
Figure 2 shows a method of touch sensing according to an embodiment.
Figure 3A shows an example heatmap.
Figure 3B shows an example baseline heatmap.
Figure 4 shows the root mean square error (RMSE) of one or more embodiments of the baseline estimation.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION OF EMBODIMENTS

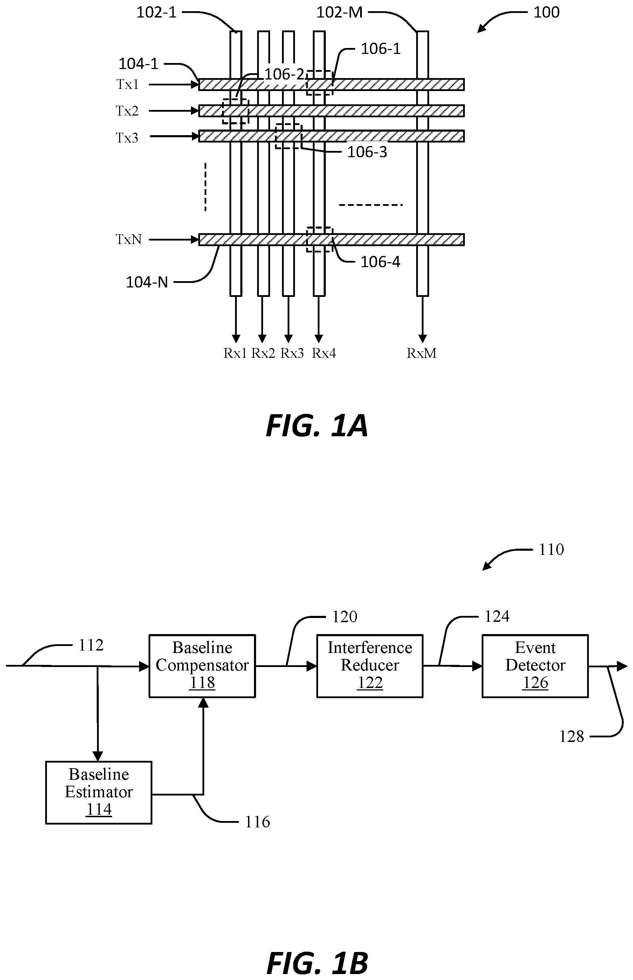

Figure 1A shows an example of a capacitive touch sensor array 100,comprising N transmit (Tx) rows 104-1, 104-2, 104-3 and M receive (Rx) columns 102-1, 102-2, 102-3, 102-M of electrodes. Each of the N transmit electrodes overlaps with each of the M receive electrodes, forming an array of crosspoints or 'cells', for example cells 106-1, 106-2, 106-3, 106-4. All electrodes are insulated from each other. The mutual capacitance between each transmit and each receive electrode can be measured, yielding an NxM array of measurement values that change over time, which may be referred to as a heatmap.

To detect a touch or proximity event, a change in the heatmap value is detected. This can be done by compensating for the 'baseline' capacitance heatmap which is also an N×M array of values for example by subtracting it from the heatmap. Such a baseline captures the expected values of the heatmap in the absence of a touch (or proximity) event. Since environmental changes, such as temperature and humidity, can change the mutual capacitance, such a baseline should adapt to slow changes.

One example baseline estimation approach is to combine the heatmaps during an initial period for example of 0.5 seconds using the average of values over the initial period. An alternative approach is to adapt the baseline using a temporal smoothing (lowpass) filter, so that it slowly tracks the stationary condition corresponding to the absence of touch events. An adaptive baseline needs to adapt to changes due to the environment caused for example by temperature or humidity changes or electronic components becoming active, but be relatively unresponsive to long touch events. A smoothing approach will react to a long touch event by slowly adapting the baseline value in the touch area to the touch activation level. If the adaptation is made very slow to be robust to touch events, it may become too slow to follow changes due to the environment. Finding a suitable adaptation speed is a tuning parameter that needs to be set, and may be difficult to optimise.

Figure 1B shows a touchscreen processor 110 including a baseline estimator 114 according to an embodiment. An input 112 which is configured to be connected to the column electrodes 102 is connected to inputs of a baseline compensator 118 and the baseline estimator 114. The baseline estimator 114 has a baseline estimator output 116 connected to an input of the baseline compensator 118. The baseline compensator118 has a baseline compensator output 120 connected to an interference reducer 122. The interference reducer 122 has an output 124 connected to an event detector 126. The output of the event detector 126 is connected to a touchscreen processor output 128. The touchscreen processor 110 may be implemented in hardware or a combination of software and hardware for example software executable on a microprocessor or microcontroller.

In operation of the touchscreen processor 110, sensor array signals Rx1, Rx2, Rx3, Rx4, RxM from the capacitive touch sensor array 100, which are represented in a heatmap, are used for estimating baseline levels for each cell 106 by the baseline estimator 114. The baseline compensator 118 compensates the actual levels by the baseline resulting in an activation map also referred to as a compensated heatmap. The compensated heatmap may be processed by the interference reducer 122 resulting in a processed compensated heatmap which is used by an event detection module 126 to detect a touch of the touchscreen. The event detection module 126 may detect, for example touch or proximity events, or palm touches.

In capacitive sensor array 100, the sensors are configured in a regular pattern. In this disclosure, the pattern is assumed to consist of rows and columns in a rectangular grid, but in other embodiment other configurations are possible. It will be understood that the term row and column as used herein may be used interchangeably. In some embodiments, the transmit signals may be transmitted via column electrodes and the sensing may be done via row electrodes. The capacitive sensor array 100 as illustrated is a rectangular configuration. The transmit electrodes are horizontal, and the receive electrodes are vertical in this case. The sensors can become contaminated by electromagnetic interferences generated by components within the touch system, or interferences generated by external sources. Such interferences will result in noise in the electrode signals and the measured heatmap. The noise can comprise random noise fluctuating around zero, a level offset, or a periodic component.

When the noise asserts itself on a transmit electrode, it is probable that all signals measuring this transmit electrode will degrade in a similar way. In that case, the same noise degradation is expected across the whole row in the heatmap. Similarly, when the noise asserts itself on a receive electrode, the same noise degradation is expected across the whole column of the heatmap.

An image which may be a spatial filter impulse response is considered to be separable if it is a product of a horizontal and a vertical function. In the context of spatial filtering, this property can be used to lower the complexity of 2D filtering operations. As an example, consider a 2D Gaussian function, centred at the origin with unit variance in both dimensions: $f \left(x, y\right) = exp \left(-\frac{{x}^{2} + {y}^{2}}{2}\right)$ $f \left(x, y\right) = exp \left(-\frac{{x}^{2}}{2}-\frac{{y}^{2}}{2}\right)$ $f \left(x, y\right) = exp \left(-\frac{{x}^{2}}{2}\right) exp \left(-\frac{{y}^{2}}{2}\right)$ $f \left(x, y\right) = {g}_{1} \left(x\right) . {g}_{2} \left(y\right)$
which is a multiplication of two functions in, respectively, *x* (horizontal function) and y (vertical function). This concept can be applied in the current context: a baseline can be constructed for each heatmap as a multiplication of a horizontal function and a vertical function, motivated by the fact that noise can assert itself on a complete row or on a complete column.

At any measuring point in time, the horizontal function can be obtained as the column-wise average of the heatmap, and the vertical function can be obtained as the row-wise average of the heatmap. For heatmap *C*(*i,j*): ${g}_{row} \left(i\right) = \frac{1}{M} {\sum }_{j} C \left(i, j\right)$ (1) ${g}_{col} \left(j\right) = \frac{1}{N} {\sum }_{i} C \left(i, j\right)$ (2)

The baseline can now be computed for each point (*i,j*) as the multiplication of g_{row}(i), which is the aggregate capacitance value of the column, and g_{col}(j), which is the aggregate capacitance value of the row, with C(i,j) denoting the capacitance value of crosspoint (i, j). The baseline needs to be appropriately scaled to have the same average value as the original heatmap: $B \left(i, j\right) = γ ⋅ {g}_{row} \left(i\right) {g}_{col} \left(j\right)$ (3) $γ = \frac{{\sum }_{i} {\sum }_{j} C \left(i, j\right)}{{\sum }_{i} {\sum }_{j} {g}_{row} \left(i\right) {g}_{col} \left(j\right)}$ (4)

Using the average for the computation of the baseline assumes that the majority of cells are at their baseline value, so the majority of values are not influenced by a touch event possibly with additive noise.

By separately determining aggregate capacitance values of the column and aggregate capacitance values of the row, and combining the values for a crosspoint, a baseline may be estimated instantaneously and independently for each frame, so at the touch sample rate. It is therefore available immediately at startup, whereas typical approaches need an initial estimation time before a baseline can be obtained. Furthermore, since it can be computed for each heatmap independently, it follows changes of the true baseline, which can be due to environmental changes or to some periodic interferences.

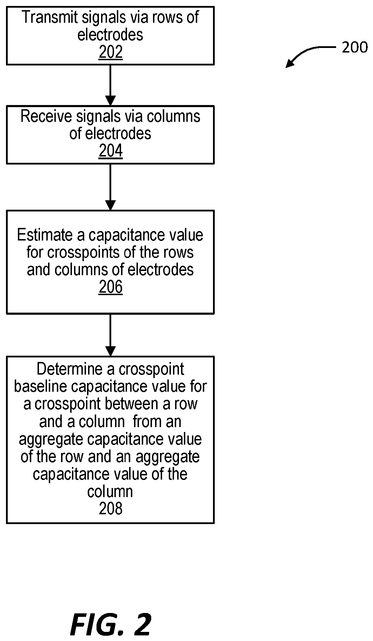

Figure 2 shows a method of touch sensing 200 for a capacitive touch sensor array 100 according to an embodiment. In step 202 signals are transmitted via rows of electrodes. In step 204, the transmitted signals are received via columns of electrodes which are capacitively coupled to the rows of electrodes. In step 206, a capacitance value is estimated for each crosspoint of the rows and columns of electrodes which may be used to form a heatmap. In step 208 a crosspoint baseline capacitance value is determined for a crosspoint between a row and a column from an aggregate capacitance value of the row and an aggregate capacitance value of the column. The aggregate capacitance value of the row may be an average of the capacitance values for a respective row at the crosspoints between the respective row and the columns, or a subset thereof. Similarly the aggregate capacitance value of the column may be an average of the capacitance values for a respective column at the crosspoints between the respective column and the rows, or a subset thereof. In other examples the aggregate capacitance value of the row or column may be a median value or truncated mean value.

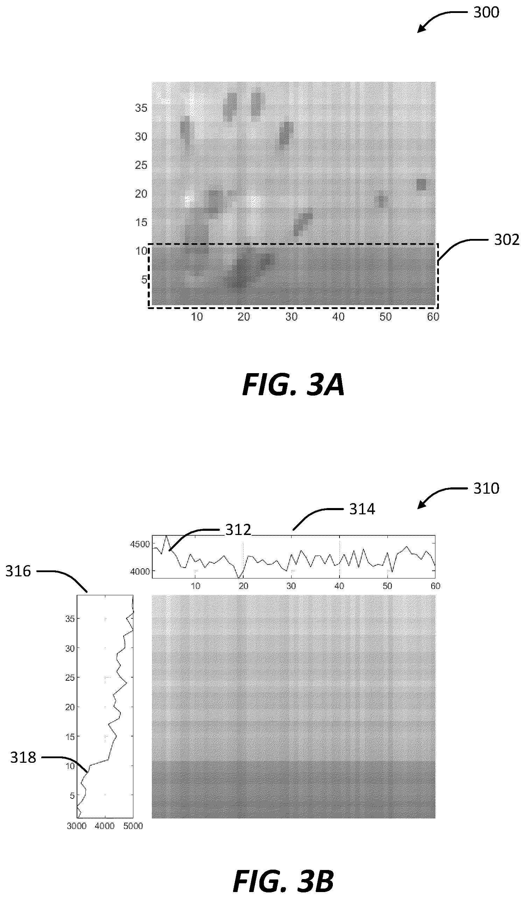

Figure 3A shows a heatmap 300 with 40 rows and 60 columns. The lower (darker) heatmap values are illustrated at the locations where the user's hand and two fingers are touching the screen. The background corresponding to the desired baseline can be observed to be mostly horizontally and vertically oriented. The lower horizontal part 302 of the heatmap has lower baseline values than the upper part. Figure 3B shows an estimated baseline 310 determined for example by method 200. The average row 312, comprising aggregate capacitance values of columns, is shown in the top panel 314 varying between 3900 and 4600 which relates to the capacitance value and the average column 318, comprising aggregate capacitance values of rows, is shown in the left panel 316. Each crosspoint in the baseline estimate is obtained as the multiplication of the corresponding values in the row and column averages (multiplied by a common scaling factor). It can be observed that the baseline estimate corresponds well to what is expected from the input heatmap. The lower horizontal part has a lower value, and the same horizontally and vertically oriented pattern is present.

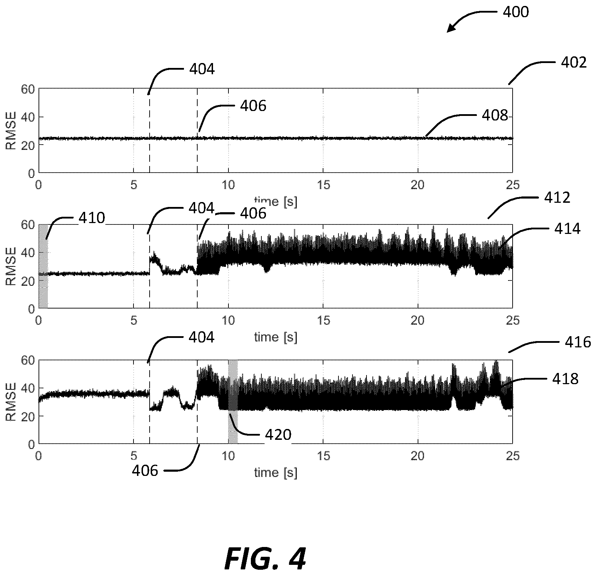

The dynamic behaviour is illustrated in the graph 400 of figure 4 in a scenario where the touchscreen is combined with a display switching on. The time duration on the x-axis is 25 seconds. The touchscreen is not touched or approached during the recording of the data. The baseline is removed to obtain an activation map. In this case, since touch events decrease the heatmap values, this operation is shown in the following equation: $act \left(i, j, k\right) = {x}_{baseline} \left(i, j, k\right) - x \left(i, j, k\right)$ (5)
where *x_{baseline}*(*i, j, k*)is the estimated baseline at row *i,* column *j* and time index *k,* and *x*(*i,j,k*) is the heatmap value at (*i,j,k*). In the activation map, a touch event would increase the activation value. Since in this case there are no touch or proximity events, the quality of the baseline can be evaluated in terms of the root mean square error (RMSE) of the activation map values, since after baseline removal, there should be no activation. $RMSE \left(k\right) = \sqrt{\frac{1}{NM} {\sum }_{i} {\sum }_{j} act {\left(i, j, k\right)}^{2}}$ (6)

The RMSE 408 is shown in the top panel 402. The display is switched on at t=5.8s corresponding to first vertical dashed line 404, and the first image is displayed at t=8.4s shown as the second dashed vertical line 406 It can be observed that the RMSE remains stable with an RMSE-value of around 25. As a comparison, two fixed baselines are considered: one is computed in the first 0.5s of the recording, shaded area 410, the other between 10s and 10.5s where the display is on corresponding to shaded area 420. The RMSE can be observed to be much more variable over time, clearly indicating that the proposed baseline captures dynamical behaviour of the baseline. In the middle panel 412, the RMSE 414 is similar to that of the proposed baseline in the segment before the display is switched on. In this segment, the baseline is stationary, as there is no interference from the display. In the segment after t=10s, the effect of the nonstationary baseline can be observed as the much larger variation of the RMSE, compared to the RMSE of the proposed baseline. In the bottom panel 416, the RMSE 418 in the first segment is higher than for the proposed baseline. In the final segment (after t=10s) the RMSE 418 is slightly smaller than the RMSE 414 in the middle panel 412 , but still much larger and more variable than for the proposed baseline.

In some embodiments, instead of the average value, other measures can be used to lower the influence of touch events, such as the median or other percentiles. These may be more robust to the influence of a touch event, which can be considered as an outlier for the (stationary) activation level of a cell. Alternatively, the truncated or trimmed mean can be used, which discards the high end and the low end of the distribution. For instance, for a row consisting of 100 points, trimming by 20% is done by sorting the values, disregarding the first 10 values and the final 10 values, and using the remaining 80 values to compute the mean.

After the proposed baseline estimation has been removed, a further baseline estimation can be performed using the more traditional techniques. This may be necessary, because not all of the interferences are separable. An example is a local hotspot, where the heatmap may increase due to a local temperature increase.

A method and apparatus of touch sensing for a capacitive touch sensor array is described. The capacitive touch sensor array includes rows and columns of electrodes. Sensor signals are transmitted via rows of electrodes and received via columns of electrodes or vice versa. A capacitance value is estimated or each crosspoint of the rows of electrodes and the plurality of columns of electrodes from the received sensor signals. A crosspoint baseline capacitance value is determined for a crosspoint between a row and a column from an aggregate capacitance value of the row and an aggregate capacitance value of the column.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A method of touch sensing for a capacitive touch sensor array, the capacitive touch sensor array comprising a plurality of rows of electrodes and a plurality of columns of electrodes, the method comprising:
transmitting a plurality of transmit signals via one of the plurality of rows of electrodes and the plurality of columns of electrodes;
receiving a plurality of sensor signals via the other of the plurality of rows of electrodes and the plurality of columns of electrodes;
estimating a capacitance value for a plurality of crosspoints between the plurality of rows of electrodes and the plurality of columns of electrodes from the plurality of sensor signals; and
determining a crosspoint baseline capacitance value for a crosspoint between a row and a column from an aggregate capacitance value of the row and an aggregate capacitance value of the column.

2. The method of claim 1, wherein determining the crosspoint baseline capacitance value further comprises multiplying the aggregate capacitance value of the row and the aggregate capacitance value of the column.

3. The method of any preceding claim, wherein
the aggregate capacitance value of the row comprises an average value of a plurality of crosspoints of the row; and
the aggregate capacitance value of the column comprises an average value of a plurality of crosspoints of the column.

4. The method of claim 1 or 2, wherein
the aggregate capacitance value of the row comprises a median value of a plurality of crosspoints of the row; and
the aggregate capacitance value of the column comprises a median value of a plurality of crosspoints of the column.

5. The method of any preceding claim, further comprising:
compensating a capacitance value for a crosspoint dependent on the crosspoint baseline capacitance value and generating a compensated heatmap from the compensated capacitance value.

6. The method of claim 5, further comprising:
processing the compensated heatmap to reduce interference.

7. The method of claim 6 further comprising:
detecting touch events from the processed compensated heatmap.

8. A touchscreen processor for a capacitive touch sensor array, the capacitive touch sensor array comprising a plurality of rows of electrodes and a plurality of columns of electrodes, the touchscreen processor comprising a baseline estimator configured to:
transmit a plurality of transmit signals via one of the plurality of rows of electrodes and the plurality of columns of electrodes;
receive a plurality of sensor signals via the other of the plurality of rows of electrodes and the plurality of columns of electrodes;
estimate a capacitance value for a plurality of crosspoints of the plurality of rows of electrodes and the plurality of columns of electrodes from the plurality of sensor signals; and
determine a crosspoint baseline capacitance value for a crosspoint between a row and a column from an aggregate capacitance value of the row and an aggregate capacitance value of the column.

9. The touchscreen processor of claim 8, wherein the baseline estimator is further configured to determine a crosspoint baseline capacitance value by multiplying the aggregate capacitance value of the row and the aggregate capacitance value of the column.

10. The touchscreen processor of claim 8 or 9, wherein
the aggregate capacitance value of the row comprises an average value of a plurality of crosspoints of the row; and
the aggregate capacitance value of the column comprises an average value of a plurality of crosspoints of the column.

11. The touchscreen processor of claim 8 or 9, wherein
the aggregate capacitance value of the row comprises a median value of a plurality of crosspoints of the row; and
the aggregate capacitance value of the column comprises a median value of a plurality of crosspoints of the column.

12. The touchscreen processor of any of claims 8 to 11, further comprising a baseline compensator coupled to the baseline estimator wherein the baseline compensator is configured to:
receive a plurality of baseline capacitance values from the baseline estimator;
compensate a capacitance value for a crosspoint dependent on the crosspoint baseline capacitance value; and
output a compensated heatmap.

13. The touchscreen processor of claim 12 further comprising an interference reducer configured to process the compensated heatmap to reduce interference.

14. The touchscreen processor of claim 13 further comprising detecting touch events from the processed compensated heatmap.

15. A non-transitory computer readable media comprising a computer program comprising computer executable instructions which, when executed by a computer, causes the computer to perform a method of touch sensing for a capacitive touch sensor array, the capacitive touch sensor array comprising a plurality of rows of electrodes and a plurality of columns of electrodes, the method comprising:
transmitting a plurality of transmit signals via one of the plurality of rows of electrodes and the plurality of columns of electrodes;
receiving a plurality of sensor signals via the other of the plurality of rows of electrodes and the plurality of columns of electrodes;
estimating a capacitance value for each crosspoint of the plurality of rows of electrodes and the plurality of columns of electrodes from the plurality of sensor signals; and
determining a crosspoint baseline capacitance value for a crosspoint between a row and a column from an aggregate capacitance value of the row and an aggregate capacitance value of the column.
